# EUROPEAN PATENT APPLICATION

(11) **EP 1 783 502 A1**
(43) Date of publication of application: **09.05.2007**
(21) Application number: 05425785.2
(22) Date of filing: 04.11.2005
(51) Int. Cl.: G01R 31/28

(54) **System and method to carry out hot and/or cold tests on electronic components and relative test chamber**

(71) Applicant: Microtest Srl, 55011 Altopascio LU (IT)
(72) Inventor: Amelio, Giuseppe, Lucca (IT)
(74) Representative: Turini, Laura

(57) **Abstract**

This invention consists of a system and method to carry out hot and/or cold tests on electronic components, using a small chamber insulated from the outside. The components inside the chamber can be simply moved from the outside, even manually, thus saving time and costs of production. It's possible to insert several components, so as to heat and/or cool them simultaneously and therefore proceed with the test. The chamber includes at least one socket (10), where the test is carried out, connected to an electronic card physically separated from said chamber. This invention also relates to the test chamber so realized.

## Description

### Technical Field

The present invention concerns the technical sector relative to the realization of systems to carry out hot or cold tests on electronic components. This invention also concerns a device, called hereinafter chamber, which permits to carry out said tests.

### Background Art

Everybody knows that electronic components must be tested before being launched on the market and inserted into more complex devices. The qualifying project of components comprises hot and/or cold tests.

Currently, very complex systems are used to carry out said tests. The most widespread one consists of a large chamber comprising a moving mechanism constituted by loading systems, moving tracks, locating systems and other. Such an apparatus is produced by the company Multitest (www.multitest.com). This apparatus allows the user to insert the components that must be tested and make them reach the desired temperature. The entire moving mechanism is included inside a large chamber that is led to the desired temperature in order to carry out the test.

This known system has the advantage to test numerous components all together, but has the relevant drawback to involve high costs of production and long time of setting. Whenever the component to be tested changes, it's often necessary to adjust or construct the internal mechanism, which inevitably requires not only costs but even and especially waste of time.

Therefore, this system cannot be used when just a few components must be tested or when the test must be carried out rapidly, for example when it's necessary to provide samples.

In order to solve this drawback, another known system carries out separate tests for every electronic component.

This technical solution makes use of a device constituted by a flexible conduit placed manually over the component to test, so as to create over the component a closed space connected to the apparatus that heats the air. Thus the conduit is placed over the component and led to the desired temperature, so that the component can be tested. After that, the conduit is lifted, the tested component is removed and a new component is inserted, proceeding as above. Actually, this system solves the problem of the structural complexity of the previous system, but has different drawbacks. In particular, it is extremely slow and every test involves high costs. As a matter of fact, if we test just one component at a time, heating is necessary every time, entailing considerable costs and delays. Therefore, this system can only be used to test just one or a few components, whereas for at least 20/30 components it is expensive and very slow compared to the results we want to reach.

### Disclosure of invention

The present invention aims at eliminating the above-mentioned and other drawbacks, supplying a system and a chamber, or device, which carry out hot and/or cold tests on electronic components rapidly and economically. This invention principally aims at carrying out tests on a limited but not too small number of components - preferably around one hundred - without the need to carry out separate tests for every component and, at the same time, without the need to use such a complex system and apparatus that entails high costs of production and long times of setting.

We reached the above and other results providing the solution described in the following description with the aid of the enclosed drawings, given as practical examples of the invention, but not to be considered restrictive.

The present invention provides a climatic mini-chamber for hot and/or cold tests on electronic components.

Any component, before its launch on the market, must follow a qualifying project comprising both hot and cold tests.

In order to carry out these temperature tests, we provide a chamber, suitably insulated, where the desired environmental conditions are reproduced by means of a thermal gun.

The climatic mini-chamber is formed by two separate portions, more precisely by a metal base, insulated from the outside, and by a glass lid of such a thickness that avoids any heat dispersion.

The metal base has a hole on the left bottom. Through said hole, the socket comprising the component to test can enter the mini-chamber and reach the desired temperature for the test. In this way, the rest of the electronic card, where the socket is welded, remains at room temperature, so preventing any premature ageing of all the components of the test board.

Out of the climatic chamber, on the shorter side, there is a hole of 5cm diameter, through which an industrial device puts in a jet of hot or cold air.

Near the device, a thermocouple measures the temperature of the air and regulates the jet of air by the thermal gun accordingly.

The component to be tested is held in a suitable socket that opens and closes by means of a metal vertical stick mechanically controlled by the outside, so that it's not necessary to open the climatic chamber at the end of any test cycle.

On the longer side of the climatic chamber there is a small slot through which a metal stick passes; said stick is equipped with a sucker at one end in order to remove and place the component in the socket.

The present invention also concerns the realization of an automatic robotic system for loading and unloading electronic components inside suitable sockets, so as to carry out tests on automatic machines either at room, hot or cold temperature.

When starting, the robot, with a speed that can be fixed externally, picks up a piece from the tray of the electronic components, suitably arranged, and places it in the socket for testing; according to the result of the test, the robot will place the component in the waste tray or in the good one.

In the case of hot and cold tests, the system is provided with a climatic mini-chamber, placed in fixed position on the aluminium plate connected to the test machine.

In this climatic chamber, the required environmental conditions are reproduced by means of the control electronics, a thermal gun and a thermostream for the cold tests.

The chamber is formed by tree separate portions, more precisely by a metal base, insulated from the outside, and by two glass lids of such a thickness that avoids any heat dispersion.

The two glass lids are separated by a gap along which the robot moves for testing the electronic components.

The electronic card, used for controlling the temperature inside the box in hot tests, is placed in the back portion and properly insulated from the hot portion, so as not to prevent its working in time. In this climatic chamber, the heating is activated by a switch and the desired temperature is set by means of a keyboard that permits also to regulate the speed of the fan that moves the air.

On the opposite side, there is a hole used by the thermostream for cold test, whereas in hot tests this hole is closed by a lid of insulating material in order to prevent the dispersion of heat.

The component to be tested is held in a suitable socket that opens and closes by means of a metal vertical stick controlled by the robot, which takes the component from the tray inside the climatic chamber and places it in the socket first and then again in the tray of tested pieces. In the cited example, there are two trays of tested pieces: one tray for the good pieces, one tray for the wastes.

On the longer sides of the box, there are two doors for inserting the trays of the pieces to test (good or waste).

Reduced to its essential structure and with reference to the figures of the enclosed drawings, a system for carrying out hot and/or cold tests on electronic components, comprises:
- means to create a room where carrying out at least one test, preferably more than one, by a small test chamber (1a), insulated from the outside, where at least one component to test is inserted, preferably more than one component simultaneously;
- means to create the desired temperature inside the chamber, by any device generating heat and/or cold (18) possibly connected to the same chamber;
- means to test at least one component, preferably more than one, by at least one socket (10) entering the chamber;
- means to move the components to and/or from the socket (10) where the test is carried out, by at least one instrument (19), such as an arm or other device, that can be moved from the outside of the chamber.

This system is particularly advantageous because it permits to carry out tests in insulated rooms and at the desired temperature, with no need to manufacture the moving mechanism present in the existing apparatus, since the movement of the components inside the chamber is possible thanks to a mobile arm (19) that can be moved from the outside by a user or a machine, such as a robot (15). Even in this last case, the system is still much easier than traditional ones.

Another advantage compared with traditional systems realized for single tests, is that in this system all the components inside the chamber are pre-heated, saving in this way times and costs of production. Once the components have reached the desired temperature, they are placed on the socket (10) that proceeds with the test. After that, the components are removed from the socket and placed on the base of the chamber or in a suitable tray (6).

Conveniently, the components are inserted all together into the chamber before their heating. They can be inserted at random or arranged in suitable trays (6). Since the base of the chamber (20) is completely free, it can be used as valid supporting base. The electric card (12) connected with the socket (10) carrying out the test is insulated from the inside of the chamber (1a) thanks to said base (20) placed between the electric card (12) and the inside of the chamber.

The chamber where the test is carried out consists of a box, preferably in steel or other material, insulated from the outside.

The heating inside the chamber is created by any suitable means. In particular, it's possible to use a thermal gun and/or other industrial device entering hot and/or cold air into the same chamber, through a suitable hole (2). Also a fan connected to a heating and/or cooling system can be used, or any other device capable of heating the inside of the chamber. Preferably, said device must be able to reach the desired temperature shortly. This purpose is obtained also thanks to the sizes of the chamber, in a non-restrictive example 46 x 32 cm x 16 cm high.

In order to control the internal temperature of the chamber and consequently regulate also the heating system, there is a device for registering the temperature: it is preferably a thermocouple (4) that measures the temperature of the air into the chamber and consequently regulates the jet of hot and/or cold air.

Said device can also consists of an electronic card controlling the temperature. The activation and/or deactivation of the heater can be also controlled by a switch and the temperature is set by means of a keyboard that permits also to regulate the speed of any fan moving the air.

Said chamber has a base (20) comprising at least one hole (5) for the passage of at least one socket (10).

The chamber can comprise a single or more sockets (10) in order to carry out several tests at the same time. This last solution can provide more openings allowing several instruments to move the components.

The socket can be placed at the base of the chamber or in any other position, e.g. laterally.

Conveniently, the socket (10) comprising the component to be tested is welded or however connected to the electronic card (12) used to carry out the test. Nevertheless, this card does not enter into contact with the inside of the chamber, as it remains completely out of the chamber, where only the socket enters. Which permits to prevent any damage to the card and to guarantee a longer life of the same card that, far from any thermal alteration, can maintain its features unchanged.

The socket holds a space for the component to be tested. There is a mechanism (11) to open and close the socket (10), so that the component enters it when open and stays still in position when closed.

The mechanism to open/close the socket can be mechanically controlled by the outside and preferably consists of a vertical stick (3). Said stick can be manually moved by a user or by a machine such as a robot or similar.

In particular, the socket can be opened and/or closed by a metal vertical stick controlled by a robot, which in this case takes the components from the tray to the socket and then takes them back in the tray of tested pieces.

The chamber is closed by at least one lid (1) or even two lids (17) that close together from their half opening.

Conveniently, said lids are made of glass or other transparent material that allows the user to see the operations fulfilled inside the chamber. Any material used is preferably a thermal insulator for preventing the dispersion of heat and possible damages due to the contact with the surface.

The chamber can even have no lid, being completely closed and equipped with at least one side door (7) for the entry/exit of the components.

The chamber also has a slot (8, 16) for the insertion of an arm or other device used to move the components inside the chamber. This slot can be located in any point of the chamber.

Conveniently, said slot is located on one side (8) of the chamber, longitudinally. It is further insulated by rubber or other material permitting the insertion and movement of the instrument and, at the same time, preventing the dispersion of heat.

This slot can be obtained by the cut of the sheet forming the box, or leaving a gap between the two lids or between a lid and other part of the chamber, or in any other method used to create an opening.

Conveniently, said slot (16) is located on the top, preferably between the two lids leaving a gap for the insertion of the instrument moving the components.

Conveniently, the instrument, arm or device, for moving the components consists of a stick (19) comprising at one end an element for catching and releasing the component to test.

Said catching element of the instrument is located inside the chamber, whereas the opposed portion of the instrument is out of the chamber and permits to move the same instrument.

Conveniently, said element consists of a pressure sucker (13). The user inserts the arm into the chamber and makes the sucker catch the component. Then, always from the outside, it places the component on the socket (10) and makes the sucker release the same component. Finally, it proceeds with another component and so on.

The components to test are inserted into the chamber before its heating. They can just rest on the base of the chamber or, preferably, be arranged in suitable trays (6) put into the chamber. Said trays can be inserted from the top raising the lid and/or laterally through suitable doors (7). Once the test is completed, the trays holding the components or the same components are removed from the lid and/or doors. One chamber can contain more trays: one for the components to test, one for the tested components, one for the tested components resulted not good. The number of trays does not affect the working of the system.

In a different practical solution, the components to test and/or already tested are not moved by a user, but automatically, preferably by a robot (15). In this case, the robot is out of the chamber, but has a vertical arm (19) entering the chamber. Said arm takes the pieces to test and places them, preferably in order, on the socket (10); it waits the test is completed and then brings the pieces in another position, among the tested components.

Conveniently, the robot is programmed for carrying out the following phases:
- to catch at least one component to test and bring it near the socket (10);
- to open the socket and insert the component to test inside;
- to wait the prefixed time corresponding to the time necessary to carry out the test;
- to open the socket again and remove the component;
- to bring the tested component in another place, out of the socket.

Conveniently, the robot works in sequence, therefore while it moves a first component, it carries out the same phases on a second component, so that the working cycle is continuous. For this reason the robot is supplied with an arm having two ends, with two catching elements, so as to work simultaneously.

Method to carry out a test on electronic components characterized in that it comprises the following phases:
- insertion of a number of components to test into a chamber (1a) insulated from the outside;
- heating and/or cooling of the inside of said chamber;
- movement of the components to test and/or already tested placed inside the same chamber, preferably following this order:
   a) positioning of a component to test on the socket;
   b) waiting of the time necessary to carry out the test;
   c) movement of the component from the socket to another part of the chamber where the components already tested are stored;
   d) back to phase a) for the next component.

System for carrying out hot and/or cold test(s) on electronic components, characterized in that it comprises:
- a small test chamber (1a), insulated from the outside, where at least one component to test is inserted, preferably more than one at the same time;
- at least one device for generating heat and/or cold (18) possibly connected to the same chamber;
- at least one socket (10) for testing at least one component;
- at least one instrument (19) entering the chamber but moved from the outside, for moving the components to test and/or already tested to and/or from the socket (10) where the test is carried out.

Said chamber consists of a box, preferably made of steel or other material, insulating from the outside.

The test chamber (1a) comprises at least one hole (5), on one side and/or on the base (20), for the passage of at least one socket (10).

The chamber can either comprise a single hole (5) for a single socket (10) or more holes for more sockets (10) in order to carry out several tests simultaneously.

The chamber can also comprise a single larger hole proportional to the number of sockets that must enter the chamber.

The chamber is closed by at least one lid (1).

The chamber can be closed by two half-lids (17) closing together on their half opening.

Said lids are made of glass or other transparent material.

Said lids are made of thermal insulating material for preventing the dispersion of heat.

The chamber can have no lid, being completely closed and equipped with at least one side door (7) for the entry and/or exit of the components to test and/or already tested.

The chamber has a slot (8, 16) permitting the insertion of an arm or other device for moving the components inside the chamber.

Said slot (8) is located on one side of the chamber, longitudinally.

Said slot is further insulated by rubber or other material permitting the insertion and movement of the instrument and, at the same time, preventing the dispersion of heat.

This slot can be obtained by the cut of the sheet forming the box, or leaving a gap between the two lids or between a lid and other part of the chamber, or in any other method used to create an opening.

Said slot (16), in a different practical solution, is located on the top, preferably between the two lids (17) leaving a gap for the insertion of the instrument moving the components.

Said slot has a prefixed length in order to permit a good movement of the instrument (19).

The chamber can comprise more slots permitting the movement of the components by more instruments.

The heating and/or cooling inside the chamber is created by a thermal gun and/or other industrial device entering hot and/or cold air into the same chamber, through a suitable hole (2).

The test chamber (1a) can comprise a fan or any industrial device for spreading hot and/or cold air into the chamber.

The test chamber comprises a device for registering the temperature: it is preferably a thermocouple (4) that measures the temperature of the air into the chamber and consequently regulates the jet of hot and/or cold air.

Said device can also consists of an electronic card controlling the temperature.

The activation and/or deactivation of the heater and/or cooler can be controlled by a switch and the temperature is set by means of a keyboard that permits also to regulate the speed of any fan moving the air.

The chamber comprises at least one socket for carrying out at least one test, preferably more sockets for carrying out more tests simultaneously.

The socket can be located at the base of the chamber or in any other position, e.g. laterally.

Said socket (10) comprising the component to be tested is welded or however connected to the electronic card (12) used to carry out the test; this card is indeed separated from the inside of the chamber from the base (20) and/or any other surface forming the same chamber.

Said socket enters the test chamber (1a) through a hole (5) located on one side and/or on the base (20) of the chamber.

Said socket holds a space for the component to be tested.

The chamber (1a) comprises a mechanism (11) to open and close the socket (10).

Said mechanism to open/close the socket can be controlled by the outside.

Said mechanism to open/close the socket consists of a stick (3), mechanically controlled by the outside.

Said mechanism to open/close the socket can consist of a metal vertical stick controlled by a robot.

Conveniently, the instrument, arm or device (19) for moving the components consists of a stick comprising at one end an element for catching and releasing the component to test.

Said catching element of the instrument is located inside the chamber, whereas the opposed portion of the instrument is out of the chamber and permits to move the same instrument.

Conveniently, said catching and/or releasing element consists of a pressure sucker (13).

The movement of the instrument (19) is controlled by a user out of the chamber (1a).

The movement of the instrument (19) is controlled by an automatic apparatus, preferably a robot (15), out of the chamber.

Said robot has a vertical arm (19) entering the chamber for the movement of the components to test and/or already tested.

Said robot opens the socket (10).

The arm (19) of said robot comprises more than one catching element, so as to move several components to test and/or already tested.

Said robot is programmed for carrying out the following phases:
- to catch at least one component to test and bring it near the socket (10);
- to open at least one socket and insert at least one component to test inside;
- to wait the prefixed time corresponding to the time necessary to carry out the test;
- to open at least one socket again and remove at least one component;
- to bring at least one tested component in another place, out of the socket.

Method to carry out a test on electronic components characterized in chat it comprises the following phases:
- insertion of at least one component to test, preferably several components simultaneously, into a chamber (1a) insulated from the outside;
- heating and/or cooling of the inside of said chamber, comprising at least one component to test, preferably more than one;
- movement of the components to test inside the chamber by means of an instrument moved from the outside, in order to place them on at least one socket;
- waiting of the time necessary to carry out the test;
- movement of at least one component from the socket to another part of the chamber where the components already tested are stored;
- possible repeating of the above phases for the next component.

Said method wherein the components to test are inserted all together into the chamber before their heating and/or cooling.

Said method wherein the components to test are inserted at random or arranged in suitable trays (6).

Said method wherein the components to test are inserted at random in any portion of the chamber or arranged in suitable trays (6).

This invention comprises a test chamber having one or more of the above-mentioned characteristics.

This invention concerns a small test chamber consisting of a box that comprises:
- at least one socket (10) for carrying out at least one test;
- at least one hole for the passage of hot and/or cold air into the chamber;
- at least one slot (8, 16) permitting the insertion of an instrument (19) into the chamber, controlled from the outside, for the movement of the components to test and/or already tested to and/or from the socket.

Said chamber where the socket enters, connected to a circuit (12), insulated from the same chamber by one side and/or the base (20) of the chamber.

Said chamber comprising a device, preferably a thermocouple, for measuring the temperature inside the chamber.

### Brief description of drawings

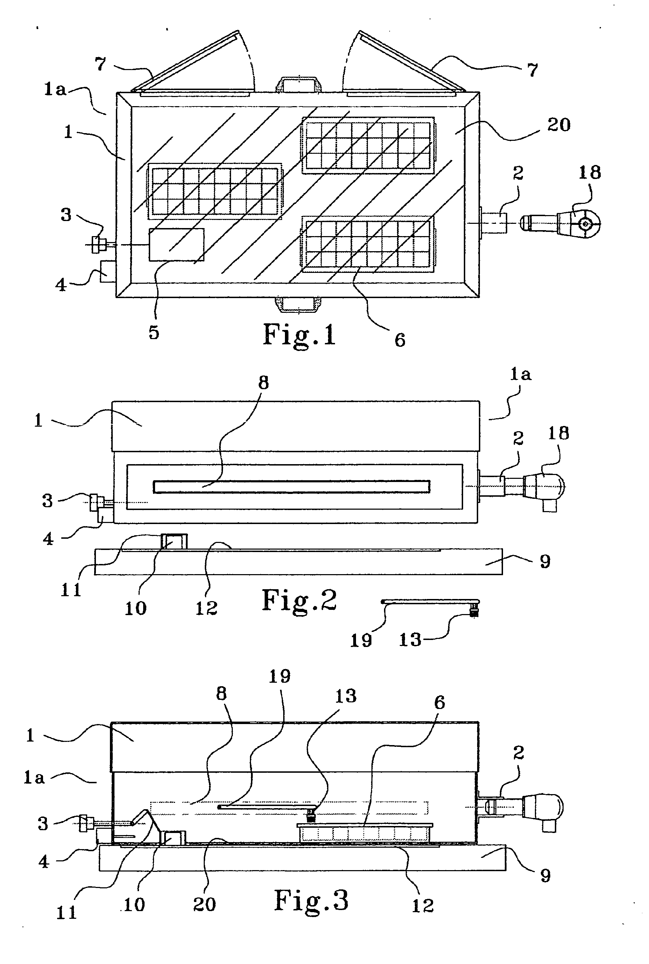

- **Fig. 1** is a top view of the chamber (1a) showing: the base (20) with a hole (5), through which the socket holding the component to be tested can enter the chamber; the lid (1) having a metal edge and the central part in glass or other transparent material, so as to see the content of the chamber and the operations carried out; a mechanism (3) for opening the socket, controlled by the outside; a thermocouple (4) and a hole (2), through which any heating or cooling device (18) puts in hot and/or cold air; the possible trays (6) holding the components to test and/or already tested and the possible doors (7), through which the trays are inserted into the chamber.
- **Fig. 2** is a side view of the same chamber showing: the slot (8), through which it's possible to move the components inside the chamber, thanks to an instrument (19) equipped with a sucker (13) at the end entering the slot (8). In this view, the lid (1) is placed over the chamber; said chamber is raised from the support (9) that comprises the electric card (12) where the socket (10), provided with opening mechanism (11), is fixed.
- **Fig. 3** finally shows the closed chamber, laid on the support (9) comprising the electric card (12); in this way, the electric card is completely insulated from the inside of the chamber by means of the base (20) and only the socket (10) can enter the chamber through the hole (5).

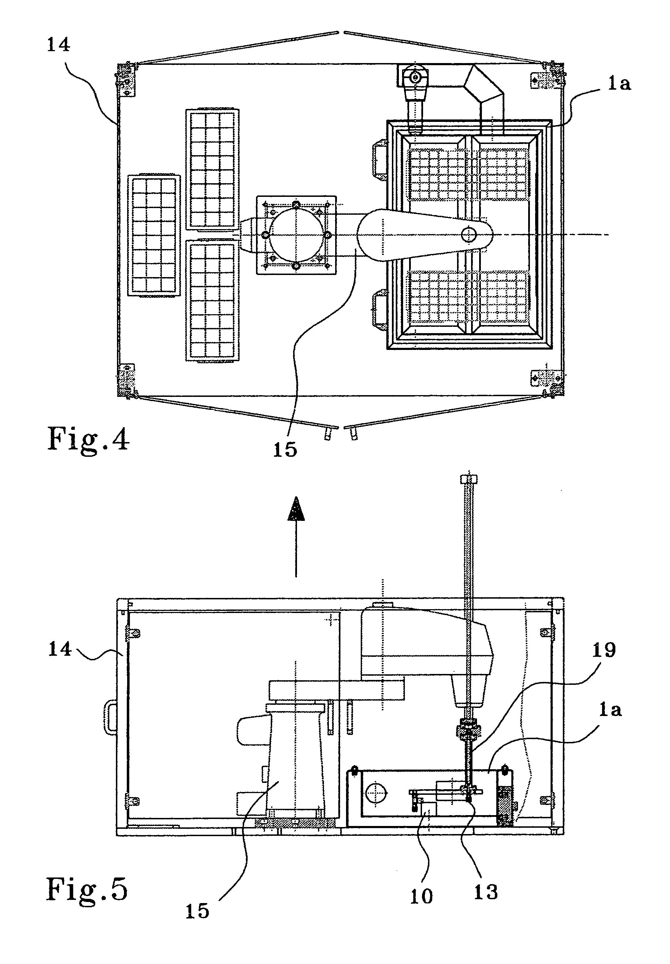

- **Fig. 4** shows a different practical solution, where the pieces inside the chamber (1a) are moved by means of a robot (15). This figure is a top view showing that both the robot and the chamber (1a) are inserted in a protective structure (14), just for security reasons, which does not alter anyway the working of the invention.
- **Fig. 5** is another top view of the same solution as Fig. 4, showing the vertical arm (19), equipped with a sucker (13) at the end entering the chamber (1a). In this example, there are two suckers in order to permit to work in sequence.

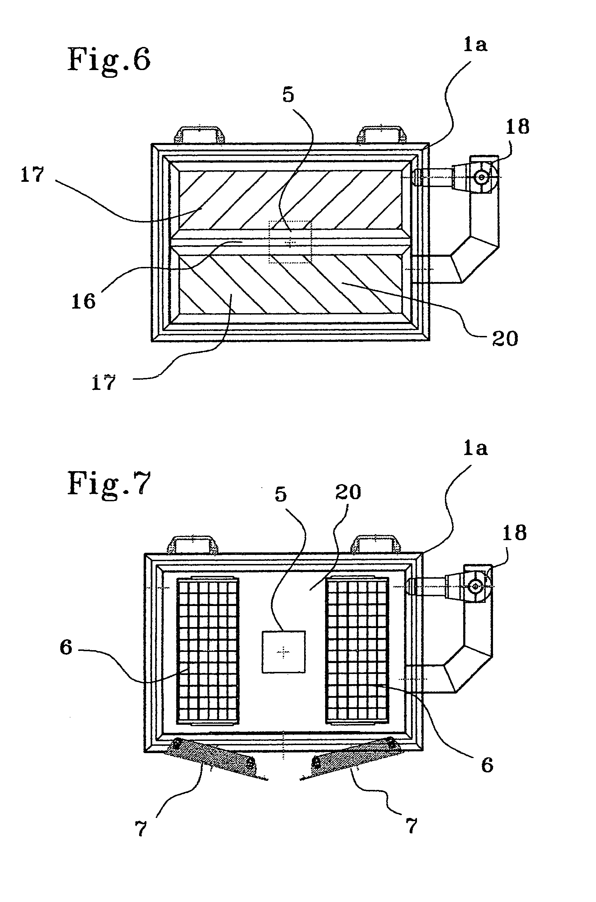

- **Fig. 6** shows a top view of another practical solution of the chamber, used with said robot, where the top is formed by two half-lids (17); the gap (16) between them allows the robot to enter its arm and thus work. This figure also shows the hole (5) at the base (20), through which the socket enters, and the hole (2) for the heating and/or cooling device (18).
- **Fig. 7** shows the same solution as Fig. 6 without the lids, with the possible trays (6), the hole (5) at the base (20) and the possible side doors (7), open for the insertion and removal of the trays.

### Best mode for carrying out the invention

One solution is represented by a chamber in stainless steel, sizes 46 x 32 cm x 16 cm high, inside which electronic components are tested. Said chamber is completely insulated from the outside and has a hole (5) on its base, through which the socket (10) passes, welded to the electric card (12) out of the chamber (1a). This chamber has also a side hole (2), through which hot and/or cold air is put inside, and a thermocouple (4) that controls the internal temperature and directly or indirectly regulates the heating and/or cooling inside the chamber. There is also a mechanism (3) to open/close the socket from the outside. The main characteristic of this chamber is that it's small and allows, in a small room and with a minimum use of apparatus, to carry out test on electronic components, even few. Since the tests are carried out in hot and/or cold conditions, the chamber is led to the desired temperature only once for all the components inserted into the same chamber. Therefore all the components, either at random or arranged in suitable trays (6), are placed into the chamber before the beginning of the heating and/or cooling process. Another essential characteristic is that the components to test are manually moved from the outside using an instrument with a portion inside and a portion outside the chamber. In this practical solution, the user takes the stick (19) at one end, while in the opposite end, inside the chamber, there is a sucker. The stick (19) enters the chamber through a side longitudinal slot (8), which allows the user to move it along the entire length of the box during the steps it takes. The user places the sucker over the component to test, possibly arranged on a tray (6), takes and moves it manually near the socket (10). Always from the outside, without opening the chamber, thanks to a lever or other device (3), the user opens the socket (11) and places the component to test inside it by means of the same stick (19). After that, the user makes the sucker release the component and closes the socket by means of the device (3). Once the test is completed, the user opens again the socket by means of the device (3), takes the tested component with the sucker (13) by means of the stick (19) and moves it in any desired position inside the box. The chamber can possibly be equipped with side doors (7) in order to insert and remove the components to test or already tested.

In a different practical solution, even if the chamber remains substantially unchanged in its manufacturing characteristics, the movement of the components is controlled, always from the outside of the chamber, by a robot (15) suitably programmed. In this case, the slot for the passage of the instrument (19) is on the top (16) and the arm fulfilling the operations is vertical. It is supplied as well with a catching element such as a sucker (13). There may be even more than one sucker in order to permit to work in sequence. The socket is always opened and/or closed automatically by means of a hook present on one end of the arm (19) of the robot.

## Claims

1. System for carrying out hot and/or cold test(s) on electronic components, **characterized in that** it comprises:
- a small test chamber (1a), insulated from the outside, where at least one component to test is inserted, preferably more than one at the same time;
- at least one device for generating heat and/or cold (18) possibly connected to the same chamber;
- at least one socket (10) for testing at least one component;
- at least one instrument (19) entering the chamber but moved from the outside, for moving the components to test and/or already tested to and/or from the socket (10) where the test is carried out.

2. Test chamber as claimed in claim 1, **characterized in that** it comprises at least one hole (5), on one side and/or on the base (20), for the passage of at least one socket (10).

3. Test chamber as claimed in claim 1, **characterized in that** it comprises a single larger hole proportional to the number of sockets that must enter the chamber.

4. Test chamber as claimed in claim 1, **characterized in that** it is closed by at least one lid (1).

5. Test chamber as claimed in claim 1, **characterized in that** it is closed by two half-lids (17) closing together on their half opening.

6. Lid as claimed in claim 4 or 5, **characterized in that** its central part is made of glass or other transparent material.

7. Lid as claimed in claim 6, **characterized in that** it is made of thermal insulating material.

8. Test chamber as claimed in claim 1, **characterized in that** it is equipped with at least one side door (7) for the entry and/or exit of the components to test and/or already tested.

9. Test chamber as claimed in claim 1, **characterized in that** it has a slot (8, 16) permitting the insertion of an outer arm or other device for moving the components inside the chamber.

10. Slot as claimed in claim 9, **characterized in that** it is located on one side (8) of the chamber, longitudinally.

11. Slot as claimed in claim 9, **characterized in that** it is insulated by rubber or other material permitting the insertion and movement of the instrument (19) and, at the same time, preventing the dispersion of heat.

12. Slot as claimed in claim 9, **characterized in that** it is located on the top (16), preferably between the two half-lids (17) leaving a gap for the insertion of the instrument moving the components.

13. System as claimed in claim 1, **characterized in that** the heating and/or cooling inside the chamber is created by a thermal gun and/or other industrial device entering hot and/or cold air into the same chamber, through a suitable hole (2).

14. System as claimed in claim 1, **characterized in that** the heating is created by means of an industrial device capable of entering hot air into the chamber.

15. System as claimed in claim 1, **characterized in that** the test chamber (1a) comprises a fan for spreading hot and/or cold air into the chamber.

16. Test chamber as claimed in claim 1, **characterized in that** it comprises a device for registering the temperature.

17. Device as claimed in claim 16, **characterized in that** it is a thermocouple (4) that measures the temperature of the air into the chamber and consequently regulates the jet of hot and/or cold air.

18. Device as claimed in claim 16, **characterized in that** it consists of an electronic card controlling the temperature.

19. Test chamber as claimed in claim 1, **characterized in that** it comprises at least one socket for carrying out at least one test, preferably more sockets for carrying out more tests simultaneously.

20. Test chamber as claimed in claim 1, **characterized in that** the socket is located at the base of the chamber.

21. Test chamber as claimed in claim 1, **characterized in that** it comprises said socket (10), which holds the component to be tested and is welded or however connected to at least one electronic card (12) used to carry out the test; this card is indeed separated from the inside of the chamber from the base (20) and/or any other surface forming the same chamber.

22. Test chamber as claimed in claim 1, **characterized in that** it comprises said socket that enters the test chamber (1a) through a hole (5) located on one side and/or on the base (20) of the chamber.

23. Test chamber as claimed in claim 1, **characterized in that** it comprises said socket that holds a space for the component to be tested.

24. Test chamber as claimed in claim 1, **characterized in that** it comprises a mechanism (11) to open and close the socket (10).

25. Mechanism as claimed in claim 24, **characterized in that** it is controlled by the outside of the chamber.

26. Mechanism as claimed in claim 24, **characterized in that** it consists of a stick (3), mechanically controlled by the outside.

27. Mechanism as claimed in claim 24, **characterized in that** it consists of a metal vertical stick controlled by a robot.

28. System as claimed in claim 1, **characterized in that** the instrument, arm or device (19) for moving the components consists of a stick comprising at one end an element for catching and releasing the component to test.

29. Instrument (19) as claimed in claim 1 or 28, **characterized in that** it its catching element is located inside the chamber, whereas the opposed portion of the instrument is out of the chamber and permits to move the same instrument.

30. Instrument (19) as claimed in claim 1 or 28, **characterized in that** said catching and/or releasing element consists of a pressure sucker (13).

31. System as claimed in claim 1, **characterized in that** it comprises a robot, out of the chamber (1a), which has an arm (19) entering the chamber for the movement of the components to test and/or already tested.

32. Robot as claimed in claim 31, **characterized in that** it opens the socket (10) as well.

33. Robot as claimed in claim 31, **characterized in that** the end of its arm (19) comprises more than one catching element, so as to move several components to test and/or already tested.

34. Robot as claimed in claim 31, **characterized in that** it is programmed for carrying out the following phases:
- to catch at least one component to test and bring it near the socket (10);
- to open at least one socket and insert at least one component to test inside;
- to wait the prefixed time corresponding to the time necessary to carry out the test;
- to open at least one socket again and remove at least one component;
- to bring at least one tested component in another place, out of the socket.

35. Method to carry out tests on electronic components **characterized in that** it comprises the following phases:
- insertion of at least one component to test, preferably several components simultaneously, into a chamber (1a) insulated from the outside;
- heating and/or cooling of the inside of said chamber, comprising at least one component to test, preferably more than one;
- movement of the components to test inside the chamber by means of an instrument moved from the outside, in order to place them on at least one socket;
- waiting of the time necessary to carry out the test;
- movement of at least one component from the socket to another part of the chamber where the components already tested are stored;
- possible repeating of the above phases for the next component.

36. Method as claimed in claim 35, **characterized in that** the components to test are inserted all together into the chamber before their heating and/or cooling.

37. Method as claimed in claim 35, **characterized in that** the components to test are inserted at random or arranged in suitable trays (6).

38. Small test chamber consisting of a box that comprises:
- at least one socket (10) for carrying out at least one test;
- at least one hole for the passage of hot and/or cold air into the chamber;
- at least one slot (8, 16) permitting the insertion of an instrument (19) into the chamber, controlled from the outside, for the movement of the components to test and/or already tested to and/or from the socket.

39. Test chamber as claimed in claim 38, **characterized in that** the socket enters the chamber and is connected to a circuit (12), insulated from the same chamber by one side and/or the base (20) of the chamber.

40. Test chamber having one or more characteristics as claimed in claims from 2 to 12 and/or from 15 to 27.
